# EUROPEAN PATENT APPLICATION

(11) **EP 4 660 976 A1**
(43) Date of publication of application: **10.12.2025**
(21) Application number: 24763012.2
(22) Date of filing: 20.02.2024
(51) Int. Cl.: G06V 40/13

(54) **FINGERPRINT RECOGNITION MODULE, DISPLAY APPARATUS AND ELECTRONIC DEVICE**

(30) Priority: 01.03.2023 CN 202310237702
(71) Applicant: Huawei Technologies Co., Ltd., Shenzhen, Guangdong 518129 (CN)
(72) Inventor: PANG, Yu, Shenzhen, Guangdong 518129 (CN); JIANG, Tao, Shenzhen, Guangdong 518129 (CN); FENG, Pengfei, Shenzhen, Guangdong 518129 (CN); CHEN, Xuying, Shenzhen, Guangdong 518129 (CN)
(74) Representative: MERH-IP Matias Erny Reichl Hoffmann Patentanwälte PartG mbB
(86) International application number: PCT/CN2024/077761
(87) International publication number: WO 2024/179329

(57) **Abstract**

Embodiments of this application provide a fingerprint recognition module, a display apparatus, and an electronic device, including: a substrate, a first ultrasonic transmit signal input port and a second ultrasonic transmit signal input port that are both disposed on the substrate, and a circuit layer, a first electrode layer, a first piezoelectric layer, a second electrode layer, a second piezoelectric layer, and a third electrode layer that are sequentially disposed on a same side of the substrate. The circuit layer includes a plurality of circuit units, the first electrode layer includes a plurality of electrode blocks spaced from each other, and the plurality of circuit units are correspondingly coupled to the plurality of electrode blocks. A polarization direction of the first piezoelectric layer is opposite to a polarization direction of the second piezoelectric layer, both the first electrode layer and the third electrode layer are coupled to the first ultrasonic transmit signal input port, and the second electrode layer is coupled to the second ultrasonic transmit signal input port. In this way, under excitation of electrodes on two sides, both the first piezoelectric layer and the second piezoelectric layer operate under excitation of an electric field. This improves transmit performance of the fingerprint recognition module.

## Description

This application claims priority to Chinese Patent Application No. 202310237702.0, filed with the China National Intellectual Property Administration on March 1, 2023 and entitled "FINGERPRINT RECOGNITION MODULE, DISPLAY APPARATUS, AND ELECTRONIC DEVICE", which is incorporated herein by reference in its entirety.

### TECHNICAL FIELD

Embodiments of this application relate to the field of display technologies, and in particular, to a fingerprint recognition module, a display apparatus, and an electronic device.

### BACKGROUND

Currently, a biometric recognition technology has been widely applied to people's daily life. Human body fingerprint information is unique and easy to use. A fingerprint imaging recognition technology is widely applied to fields such as electronic products and smart home.

In the fingerprint imaging recognition technology, a fingerprint image of a human body is recognized via a fingerprint sensor, and the recognized fingerprint is compared with fingerprint information that is pre-recognized and stored in a system, to implement identity recognition. Currently, common fingerprint imaging recognition technologies include a capacitive type, an optical type, an ultrasonic type, and the like.

In an ultrasonic fingerprint recognition module, the ultrasonic fingerprint recognition module may transmit an ultrasonic wave to a to-be-detected object through an ultrasonic transmission medium, and receive an ultrasonic wave reflected back by the to-be-detected object, to complete detection of the to-be-detected object.

However, a penetration capability of the ultrasonic wave directly affects detection accuracy and sensitivity of the fingerprint recognition module, thereby affecting user experience.

### SUMMARY

Embodiments of this application provide a fingerprint recognition module, a display apparatus, and an electronic device, to improve receiving and sending performance of the fingerprint recognition module.

According to a first aspect of embodiments of this application, a fingerprint recognition module is provided, including: a substrate, a first ultrasonic transmit signal input port and a second ultrasonic transmit signal input port that are both disposed on the substrate, and a circuit layer, a first electrode layer, a first piezoelectric layer, a second electrode layer, a second piezoelectric layer, and a third electrode layer that are sequentially disposed on a same side of the substrate. The circuit layer includes a plurality of circuit units spaced from each other, the first electrode layer includes a plurality of electrode blocks spaced from each other, and the plurality of circuit units are correspondingly coupled to the plurality of electrode blocks. A polarization direction of the first piezoelectric layer is opposite to a polarization direction of the second piezoelectric layer, both the first electrode layer and the third electrode layer are coupled to the first ultrasonic transmit signal input port, and the second electrode layer is coupled to the second ultrasonic transmit signal input port. In this way, the fingerprint recognition module provided in embodiments of this application includes at least two piezoelectric layers: the first piezoelectric layer and the second piezoelectric layer. When a signal is transmitted, under excitation of electrodes on two sides, both the first piezoelectric layer and the second piezoelectric layer operate under excitation of an electric field. This increases electric field strength at the piezoelectric layer, and improves transmit performance of the fingerprint recognition module, and a penetration capability of a transmitted ultrasonic wave is stronger.

In an optional implementation, the fingerprint recognition module further includes an echo signal output port, and the echo signal output port is coupled to the circuit layer. In this way, in a signal receiver phase of the fingerprint recognition module, the reflected ultrasonic wave reaches the first piezoelectric layer, the first piezoelectric layer vibrates at a high frequency under driving of the reflected ultrasonic wave, and converts the vibration into an electrical signal. The circuit layer receives the electrical signal, and outputs the electrical signal via the echo signal output port, to receive echo signals.

In an optional implementation, a thickness of the first piezoelectric layer is greater than 1/2 of a total thickness of the first piezoelectric layer and the second piezoelectric layer. In this way, the thickness of the piezoelectric layer is adjusted, so that the first piezoelectric layer is thicker, and a potential difference generated by charge accumulation in a thickness direction of the first piezoelectric layer is larger, thereby improving receiving performance. In addition, a signal difference between a "valley" and a "ridge" that are of a finger surface and that are obtained through imaging by the fingerprint recognition module is increased, and imaging effect is better.

In an optional implementation, the total thickness of the first piezoelectric layer and the second piezoelectric layer is 5 µm to 30 µm. Therefore, thicknesses of the two piezoelectric layers are small, and are close to a thickness of an existing single piezoelectric layer. This improves transmit performance of the fingerprint recognition module without increasing the total thickness of the piezoelectric layers.

In an optional implementation, the second piezoelectric layer includes a plurality of piezoelectric units arranged in an array, and the piezoelectric units one-to-one correspond to the electrode blocks. In this way, crosstalk between different pixels existing when the fingerprint recognition module performs receiving can be reduced.

In an optional implementation, the first piezoelectric layer includes a plurality of piezoelectric units arranged in an array, and the piezoelectric units one-to-one correspond to the electrode blocks. In this way, crosstalk between different pixels when the fingerprint recognition module performs receiving can be further reduced.

In an optional implementation, the second electrode layer includes a plurality of electrode units arranged in an array, and the electrode units one-to-one correspond to the electrode blocks. In this way, crosstalk between different pixels when the fingerprint recognition module performs receiving can be further reduced.

In an optional implementation, the substrate is connected to the display through a first connection layer. In this way, the first connection layer may implement a bonding function, and may further transmit an ultrasonic wave between the fingerprint recognition module and the display, to implement acoustic coupling.

In an optional implementation, the fingerprint recognition module further includes a protective layer, and the protective layer is disposed on a side that is of the third electrode and that is away from the substrate. In this way, the protective layer can better protect the fingerprint recognition module.

In an optional implementation, the second electrode layer includes: a first sub-electrode layer, a second connection layer, and a second sub-electrode layer that are disposed in a stacked manner, the first sub-electrode layer is connected to the first piezoelectric layer, the second sub-electrode layer is connected to the second piezoelectric layer, and the first sub-electrode layer is connected to the second sub-electrode layer through the second connection layer. In this way, the second electrode layer is divided into a plurality of layers, to facilitate disassembly and installation.

In an optional implementation, the fingerprint recognition module further includes a third piezoelectric layer. The third piezoelectric layer is located on the side that is of the third electrode layer and that is away from the first piezoelectric layer, and a polarization direction of the third piezoelectric layer is opposite to the polarization direction of the second piezoelectric layer. In this way, the third piezoelectric layer is disposed, so that the first piezoelectric layer, the second piezoelectric layer, and the third piezoelectric layer all operate under excitation of an electric field. This further improves transmit performance of the fingerprint recognition module, and a penetration capability of a transmitted ultrasonic wave is stronger.

In an optional implementation, a fourth electrode layer is further included. The fourth electrode layer is located on a side that is of the third piezoelectric layer and that is away from the substrate, and the fourth electrode layer is coupled to the second ultrasonic transmit signal input port. In this way, when a signal is transmitted, the third piezoelectric layer operates under excitation of the fourth electrode and the third electrode.

In an optional implementation, the display includes a cover and a display panel, and the fingerprint recognition module is located on a side that is of the display panel and that is away from the cover. In this way, the fingerprint recognition module may be disposed below the display, to avoid affecting image display of the display.

In an optional implementation, the first ultrasonic transmit signal input port and the second ultrasonic transmit signal input port are configured to receive different excitation signals. In this way, the polarization direction of the first piezoelectric layer can be opposite to the polarization direction of the second piezoelectric layer.

According to a second aspect of embodiments of this application, a display apparatus is provided, including a display and the fingerprint recognition module described above. In this way, the display apparatus uses the fingerprint recognition module, so that ultrasonic manipulation performance is better, and a captured fingerprint image is clearer.

In an optional implementation, the display includes a touch contact layer, where the touch contact layer is disposed on a side that is of the substrate and that faces away from the third electrode layer; or the touch contact layer is disposed on a side that is of the third electrode layer and that faces away from the substrate. In this way, a front label and a back label of the fingerprint recognition module are implemented.

According to a third aspect of embodiments of this application, an electronic device is provided, including a processor and the foregoing display apparatus. The processor is in a signal connection to the fingerprint recognition module. In this way, the electronic device uses the fingerprint recognition module, so that ultrasonic manipulation performance is better, and a captured fingerprint image is clearer.

According to a fourth aspect of embodiments of this application, an operating method of a fingerprint recognition module is provided. The fingerprint recognition module includes: a first ultrasonic transmit signal input port, a second ultrasonic transmit signal input port, a circuit layer, a first electrode layer, a first piezoelectric layer, a second electrode layer, a second piezoelectric layer, and a third electrode layer that are disposed on the substrate. The circuit layer includes a plurality of circuit units spaced from each other, the first electrode layer includes a plurality of electrode blocks spaced from each other, and the plurality of circuit units are correspondingly coupled to the plurality of electrode blocks. A polarization direction of the first piezoelectric layer is opposite to a polarization direction of the second piezoelectric layer. The operating method of the fingerprint recognition module includes: In a transmitter phase, the first ultrasonic transmit signal input port receives a first excitation signal, and transmits the first excitation signal to the first electrode layer and the third electrode layer; the second ultrasonic transmit signal input port receives a second excitation signal, and transmits the second excitation signal to the second electrode layer, where the first piezoelectric layer transmits a first ultrasonic wave under excitation of a first electric field formed by the first excitation signal and the second excitation signal on two sides of the first piezoelectric layer; the second piezoelectric layer transmits a second ultrasonic wave under excitation of a second electric field formed by the second excitation signal and the first excitation signal on two sides of the second piezoelectric layer; and an electric field direction of the first electric field is opposite to an electric field direction of the second electric field; and in a receiver phase, the first piezoelectric layer vibrates under driving of a reflected ultrasonic wave, and converts the vibration into an electrical signal. The circuit layer receives the electrical signal, and outputs the electrical signal via an echo signal output port. In this way, the fingerprint recognition module provided in embodiments of this application includes at least two piezoelectric layers: the first piezoelectric layer and the second piezoelectric layer. When a signal is transmitted, under excitation of electrodes on two sides, both the first piezoelectric layer and the second piezoelectric layer operate under excitation of an electric field. This increases electric field strength at the piezoelectric layer, and improves transmit performance of the fingerprint recognition module, and a penetration capability of a transmitted ultrasonic wave is stronger. When a signal is received, because the first piezoelectric layer is closer to the circuit layer of the substrate, the signal may be received through the first piezoelectric layer. In some embodiments, thicknesses of the first piezoelectric layer and the second piezoelectric layer may be adjusted, so that the first piezoelectric layer is thicker, and a potential difference generated by charge accumulation in a thickness direction of the first piezoelectric layer is larger, thereby improving receiving performance. In addition, a signal difference between a "valley" and a "ridge" that are of a finger surface and that are obtained through imaging by the fingerprint recognition module is increased, and imaging effect is better. In this way, receiving and sending performance of the fingerprint recognition module is improved.

### BRIEF DESCRIPTION OF DRAWINGS

FIG. 1 is a diagram of a structure of an electronic device according to an embodiment of this application;
FIG. 2 is a diagram of a use status of a fingerprint recognition module according to an embodiment of this application;
FIG. 3 is a diagram of a structure of a fingerprint recognition module;
FIG. 4 is a diagram of a structure of a fingerprint recognition module according to an embodiment of this application;
FIG. 5 is a diagram of an application architecture of a fingerprint recognition module according to an embodiment of this application;
FIG. 6 is a diagram of an application architecture of another fingerprint recognition module according to an embodiment of this application;
FIG. 7 is a diagram of a manner of loading an excitation signal of a fingerprint recognition module according to an embodiment of this application;
FIG. 8 is a diagram of another manner of loading an excitation signal of a fingerprint recognition module according to an embodiment of this application;
FIG. 9 is a diagram of a signal receiving manner of a fingerprint recognition module according to an embodiment of this application;
FIG. 10 is a curve diagram of acoustic pressure of a transmit wave of the fingerprint recognition module shown in FIG. 3 and FIG. 4;
FIG. 11 is a diagram of a structure of another fingerprint recognition module according to an embodiment of this application;
FIG. 12 is a curve diagram in which echo signal strength of the fingerprint recognition module in FIG. 11 varies with a thickness of a first piezoelectric layer;
FIG. 13 is a simulation diagram of imaging effect of the fingerprint recognition module in FIG. 11 and FIG. 3;
FIG. 14 is a diagram of a structure of another fingerprint recognition module according to an embodiment of this application;
FIG. 15 is a diagram of a structure of another fingerprint recognition module according to an embodiment of this application;
FIG. 16 is a diagram of a structure of another fingerprint recognition module according to an embodiment of this application;
FIG. 17 is a simulation diagram of imaging effect of the fingerprint recognition module in FIG. 6, FIG. 14, FIG. 15, and FIG. 16;
FIG. 18 is a diagram of a structure of another fingerprint recognition module according to an embodiment of this application; and
FIG. 19 is a diagram of a structure of another fingerprint recognition module according to an embodiment of this application.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms "first" and "second" mentioned below are merely intended for a purpose of description, and shall not be understood as an indication or implication of relative importance or implicit indication of the quantity of indicated technical features. Therefore, a feature limited by "first", "second", or the like may explicitly or implicitly include one or more features. In descriptions of this application, unless otherwise stated, "a plurality of" means two or more than two.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

In this application, unless otherwise specified and limited, the term "connection" should be understood in a broad sense. For example, the "connection" may be a fixed connection, a detachable connection, an integration, a direct connection, or an indirect connection through an intermediate medium.

The following explains terms that may be used in this application.

Coupling: The coupling is also referred to as a "coupling connection", and may be understood as a direct coupling connection and/or an indirect coupling connection. The direct coupling may also be referred to as an "electrical connection", which may be understood as physical contact and electrical conduction of components, or may be understood as a form of connection between different components in a line structure through a physical line that can transmit an electrical signal, for example, a printed circuit board (printed circuit board, PCB) copper foil or a conducting wire. The "indirect coupling" may be understood as electrical conduction of two conductors in a spaced/non-contact manner. In an embodiment, the indirect coupling may also be referred to as capacitive coupling. For example, signal transmission is implemented by forming an equivalent capacitor through coupling in a gap between two spaced conductive members.

As a mainstream interaction manner, biometric feature recognition (for example, fingerprint recognition) is widely applied to user identification, unlocking, secure payment, and the like on a mobile phone end, and has become an indispensable function of a current mobile phone. In addition, in daily home life, including scenarios such as a tablet, a laptop, a door lock, and the like, a user identity is confirmed through fingerprint recognition. In addition, a potential application burst point of fingerprint recognition is on an intelligent vehicle, for example, on a vehicle door handle. A user identity of a driver is authenticated through fingerprint recognition, to open a door of the vehicle, thereby thoroughly eliminating hassle of a vehicle key. In addition, fingerprint unlocking inside the vehicle may further include engine ignition. When the driver presses a button to start the vehicle, the vehicle performs authentication by using a fingerprint. More conveniently, fingerprint unlocking may be used, by recording information of different drivers and recording setting habits of the drivers in a driving process, to authenticate the different drivers after the vehicle is started, and load user habits and cockpit settings (such as a seat and a rear view mirror). For family members, it is a very friendly user experience improvement. Therefore, a biometric recognition technology has great research value.

An embodiment of this application provides an electronic device. The electronic device has a biometric feature detection function for a pressing object. For example, a fingerprint, a palm print, or a handprint of a hand may be detected. The electronic device is, for example, a consumer electronic product, a home electronic product, or a vehicle-mounted electronic product with a biometric feature detection function. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, a game device, or an intelligent wearable product (for example, a smart watch, a smart band, smart jewelry), a virtual reality (virtual reality, VR) electronic device device, an augmented reality (augmented reality, AR) electronic device device, a drone, an electronic database, or a bank automated teller machine. The home electronic product is, for example, a smart door lock, a television, a remote control, a refrigerator, or a small charging home appliance (for example, a soy milk maker or a robot vacuum cleaner). The vehicle-mounted electronic product is, for example, a vehicle-mounted navigator, a vehicle-mounted high-density digital video disc (digital video disc, DVD), a vehicle door handle, or an engine ignition system. The electronic device may be an electronic device having a display function, or the electronic device may be an electronic device having no display function. This is not limited in embodiments of this application.

The following uses an example in which the electronic device is a mobile phone for description.

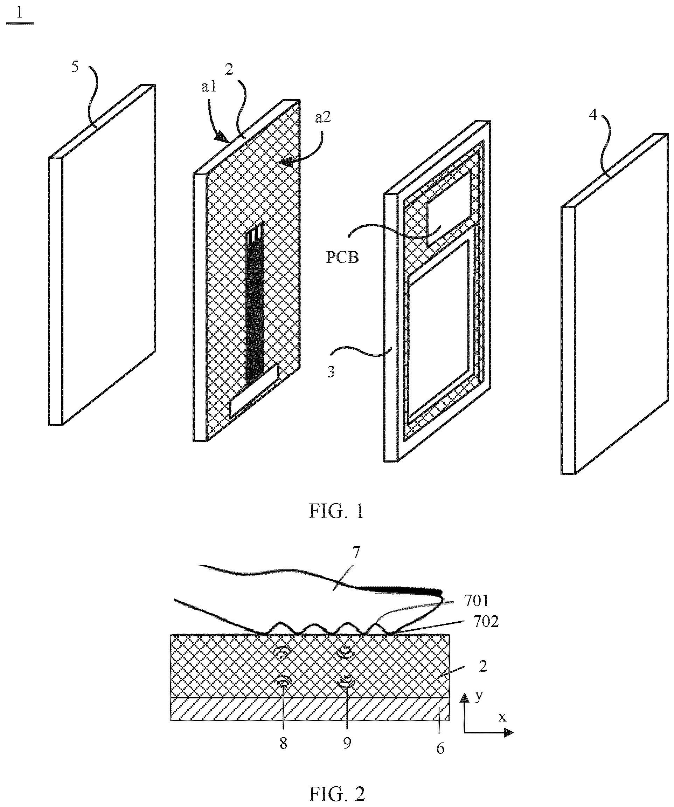

As shown in FIG. 1, the electronic device 1 includes a display panel 2, a middle frame 3, a housing (or referred to as a battery cover or a rear housing) 4, and a cover 5.

The display panel 2 has a light-emitting surface a1 on which a display image can be seen and a rear surface a2 disposed opposite to the light-emitting surface a1, the rear surface a2 of the display panel 2 is close to the middle frame 3, and the cover 5 is disposed on the light-emitting surface a1 of the display panel 2.

In a possible embodiment of this application, the display panel 2 is an organic light-emitting diode (organic light-emitting diode, OLED) display. Because an electroluminescent layer is disposed in each light-emitting subpixel in the OLED display, the OLED display can implement self-luminance after receiving an operating voltage.

In another possible implementation, the display panel 2 is a liquid crystal display (Liquid Crystal Display, LCD).

The cover 5 is located on a side that is of the display panel 2 and that is away from the middle frame 3. The cover 5, for example, may be cover glass (cover glass, CG), and the cover glass may have specific toughness.

The middle frame 3 is located between the display panel 2 and the housing 4. A surface that is of the middle frame 3 and that is away from the display panel 2 is used to install internal components such as a battery, a printed circuit board (printed circuit board, PCB), a camera (camera), and an antenna. After the housing 4 covers the middle frame 3, the internal components are located between the housing 4 and the middle frame 3.

On this basis, as shown in FIG. 2, the electronic device 1 further includes a fingerprint recognition module 6 disposed below the display panel 2.

Refer to FIG. 2. According to an intelligent electronic device provided in this embodiment of this application, when fingerprint recognition is performed, a human finger 7 is placed on the display panel 2. When a fingerprint image is captured, the fingerprint recognition module 6 sends an imaging signal 8 upward. After the imaging signal 8 sent by the fingerprint recognition module reaches a surface of the finger, a "valley" 701 and a "ridge" 702 on the surface of the finger reflect the imaging signal 8 differently, A reflected signal 9 reflected by the surface of the finger returns to the fingerprint recognition module 6. The fingerprint recognition module 6 receives the reflected signal 9, and performs signal conversion and signal processing on the received reflected signal 9, to capture a fingerprint image.

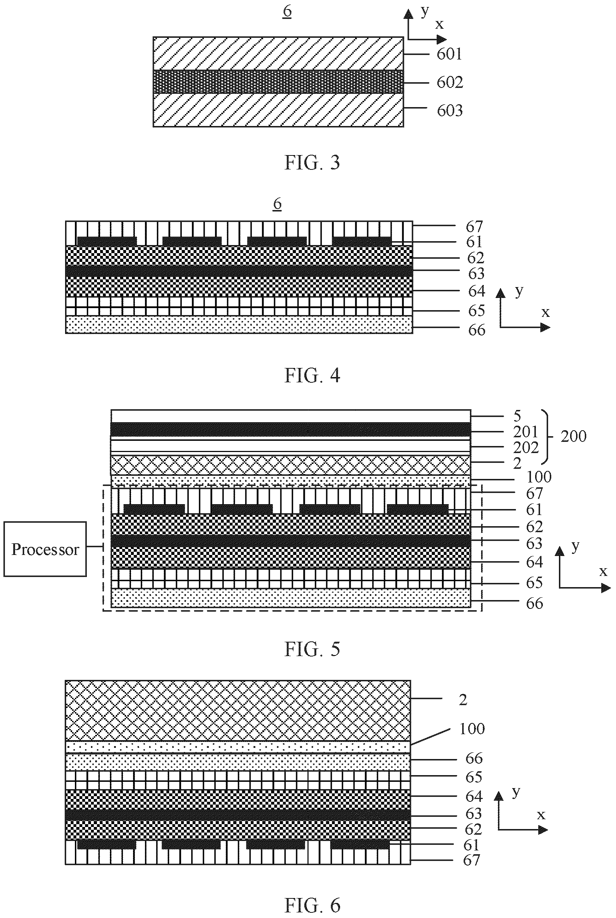

As shown in FIG. 3, an existing fingerprint recognition module includes ultrasonic fingerprint recognition modules that are disposed in a stacked manner, and the ultrasonic fingerprint recognition module includes a first electrode layer 601, a piezoelectric layer 602, and a second electrode layer 603 that are disposed in a stacked manner. Only one piezoelectric layer is disposed in the fingerprint recognition module.

Although the fingerprint recognition module can recognize a pressing object, an ultrasonic penetration capability is insufficient. Consequently, the fingerprint recognition module is not applicable to an OLED display with a tempered glass film of a specific thickness. When the fingerprint recognition module is used in an electronic device with the OLED display with the tempered glass film, information about the pressing object cannot be accurately and effectively recognized based on echo signal amplitude. The fingerprint recognition module may also be used below another display, for example, glass or metal, to implement a function of recognizing a pressing object. However, the fingerprint recognition module also faces a problem of an insufficient penetration capability.

Therefore, an embodiment of this application provides an improved fingerprint recognition module. The fingerprint recognition module includes at least two piezoelectric layers.

FIG. 4 is a diagram of a structure of a fingerprint recognition module according to an embodiment of this application. As shown in FIG. 4, the fingerprint recognition module 6 includes a first electrode layer 61, a first piezoelectric layer 62, a second electrode layer 63, a second piezoelectric layer 64, and a third electrode layer 65 that are disposed in a stacked manner.

For example, the first electrode layer 61 includes a plurality of electrode blocks disposed in an array, which are similar to pixel electrodes in a display. A material of the first electrode layer 61 includes a conductive material like indium tin oxide (Indium tin oxide, ITO), aluminum (Al), or copper (Cu). The first electrode layer 61 may discretize a pattern signal of a fingerprint, to form different grayscale images.

The first piezoelectric layer 62 and the second piezoelectric layer 64 may use a same material, and the material of the first piezoelectric layer 62 and the second piezoelectric layer 64 includes a polymer piezoelectric material, for example, polyvinylidene fluoride (PVDF) or polyvinylidene fluoride-trifluoroethylene (PVDF-TrFE); or a ceramic piezoelectric material, for example, lead zirconate titanate (PZT) or aluminum nitride (AlN).

The first piezoelectric layer 62 and the second piezoelectric layer 64 may generate an ultrasonic wave under voltage excitation between electrodes, and may also convert a reflected ultrasonic wave into an electrical signal.

Materials of the second electrode layer 63 and the third electrode layer 65 include conductive materials such as silver paste, indium tin oxide (ITO), aluminum (Al), and copper (Cu). In an embodiment, the second electrode layer 63 and the third electrode layer 65 may be electrode layers of an entire surface. In another embodiment, at least one of the second electrode layer 63 and the third electrode layer 65 may use a graphical structure, similar to the first electrode layer 61 including the plurality of electrode blocks disposed in the array.

In some embodiments, the fingerprint recognition module 6 further includes a substrate 67, and the substrate 67 is connected to the first electrode 61. In some embodiments, the first electrode layer 61 is formed on the substrate 67 by using an electrode array.

Materials of the substrate 67 include: glass, silicon wafer, polyimide (Polyimide, PI), polyethylene terephthalate (PET), and other polymer materials. For example, the substrate 67 may be a glass substrate.

The substrate 67 may be used as a substrate of the first piezoelectric layer, or may be a silicon chip having a circuit structure. A pixel circuit unit or an analog-digital circuit unit is formed inside the substrate 67. A structure of the substrate 67 is not limited in embodiments of this application.

In an embodiment, the substrate 67 further includes a circuit layer.

In an embodiment, the circuit layer is disposed in the substrate 67.

In an embodiment, the circuit layer is disposed on a surface of the substrate 67, and the circuit layer, the first electrode layer 61, the first piezoelectric layer 62, the second electrode layer 63, the second piezoelectric layer 64, and the third electrode layer 65 are sequentially disposed on the substrate 67.

For example, as shown in FIG. 4, the substrate 67, the circuit layer (not shown in the figure), the first electrode layer 61, the first piezoelectric layer 62, the second electrode layer 63, the second piezoelectric layer 64, and the third electrode layer 65 are sequentially disposed in a stacked manner in a y direction.

The circuit layer includes a plurality of circuit units spaced from each other, the first electrode layer includes a plurality of electrode blocks spaced from each other, and the plurality of circuit units are correspondingly coupled to the plurality of electrode blocks of the first electrode layer 61.

In some embodiments, a polarization direction of the first piezoelectric layer 62 is opposite to a polarization direction of the second piezoelectric layer 64.

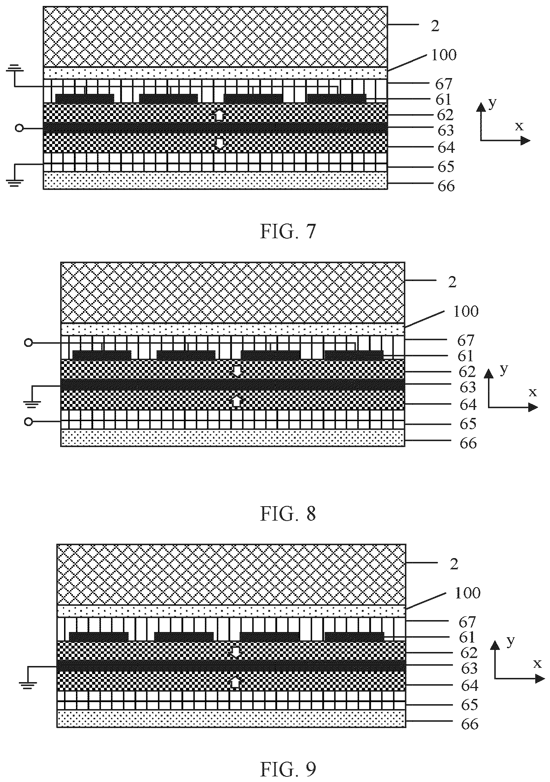

Polarization directions of the first piezoelectric layer 62 and the second piezoelectric layer 64 may be directions indicated by arrows in FIG. 7, FIG. 8, and FIG. 9.

As shown in FIG. 7, the polarization directions of the first piezoelectric layer 62 and the second piezoelectric layer 64 face away from the second electrode layer 63; or as shown in FIG. 8 and FIG. 9, the polarization directions of the first piezoelectric layer 62 and the second piezoelectric layer 64 may face the second electrode layer. This is not limited in embodiments of this application.

In an embodiment, the fingerprint recognition module further includes a first ultrasonic transmit signal input port and a second ultrasonic transmit signal input port. Both the first ultrasonic transmit signal input port and the second ultrasonic transmit signal input port are disposed on the substrate 67.

In an embodiment, both the first electrode layer 61 and the third electrode layer 65 are coupled to the first ultrasonic transmit signal input port, and the second electrode layer 63 is coupled to the second ultrasonic transmit signal input port.

The first ultrasonic transmit signal input port and the second ultrasonic transmit signal input port are configured to receive different excitation signals.

For example, as shown in FIG. 7, the first electrode layer 61 and the third electrode layer 65 receive a first excitation signal (a ground signal or a fixed level signal) input by the first ultrasonic transmit signal input port, and the second electrode layer 63 is configured to receive a second excitation signal (a pulse signal) input by the second ultrasonic transmit signal input port.

Alternatively, as shown in FIG. 8, the first electrode layer 61 and the third electrode layer 65 are configured to receive a second excitation signal (a pulse signal) input by the first ultrasonic transmit signal input port, and the second electrode layer 63 receives a first excitation signal (a ground signal or a fixed level signal) input by the first ultrasonic transmit signal input port. The first excitation signal and the second excitation signal are different excitation signals. For example, the first excitation signal and the second excitation signal are high and low level signals of each other.

In some embodiments, both the first electrode layer 61 and the third electrode layer 65 are coupled to a first ultrasonic transmit signal input port, and are configured to receive a first excitation signal (for example, a transmit instruction transmitted by a processor to the fingerprint recognition module) received at the first ultrasonic transmit signal input port.

The first electrode layer 61 and the third electrode layer 65 may be directly coupled to the first ultrasonic transmit signal input port, or may be indirectly coupled to the first ultrasonic transmit signal input port.

The second electrode layer 63 is coupled to a second ultrasonic transmit signal input port, and is configured to receive a second excitation signal (for example, a transmit instruction transmitted by the processor to the fingerprint recognition module) received at the second ultrasonic transmit signal input port.

The second electrode layer 63 may be directly coupled to the second ultrasonic transmit signal input port, or may be indirectly coupled to the second ultrasonic transmit signal input port.

For example, as shown in FIG. 7, the first excitation signal is a low-level constant-voltage excitation signal, and the second excitation signal is a high-level excitation signal.

It may be understood that the high level and the low level in embodiments of this application are relative, and are not absolute high level and low level. The low-level constant-voltage excitation signal is a low-level signal relative to the high-level excitation signal. Similarly, the high-level excitation signal is a high-level signal relative to the low-level constant-voltage excitation signal.

For example, the low-level constant voltage excitation signal is a reference ground voltage.

In this case, the first electrode layer 61 receives a low-level constant-voltage excitation signal transmitted at the first ultrasonic transmit signal input port, and the second electrode layer 63 receives a high-level excitation signal transmitted at the second ultrasonic transmit signal input port. A voltage on a lower side of the first piezoelectric layer 62 is high, and a voltage on an upper side of the first piezoelectric layer 62 is low, to form a first electric field in a +y direction. The first piezoelectric layer 62 transmits a first ultrasonic wave under excitation of the first electric field. The third electrode layer 65 receives the low-level constant-voltage excitation signal transmitted at the first ultrasonic transmit signal input port. A voltage on a lower side of the second piezoelectric layer 64 is low, and a voltage on an upper side of the second piezoelectric layer 64 is high, to form a second electric field in a -y direction. The second piezoelectric layer 64 transmits a second ultrasonic wave under excitation of the second electric field. As shown in FIG. 7, a polarization direction of the first piezoelectric layer 62 is opposite to a polarization direction of the second piezoelectric layer 64.

Alternatively, for example, as shown in FIG. 8, the first excitation signal is a high-level excitation signal, and the second excitation signal is a low-level constant-voltage excitation signal.

In this case, the first electrode layer 61 receives the high-level excitation signal transmitted at the first ultrasonic transmit signal input port, the second electrode layer 63 receives the low-level constant-voltage excitation signal transmitted at the second ultrasonic transmit signal input port. A voltage on a lower side of the first piezoelectric layer 62 is low, and a voltage on an upper side of the first piezoelectric layer 62 is high, to form a first electric field in a -y direction. The first piezoelectric layer 62 transmits a first ultrasonic wave under excitation of the first electric field. The third electrode layer 65 receives the high-level excitation signal transmitted at the first ultrasonic transmit signal input port. A voltage on an upper side of the second piezoelectric layer 64 is low, and a voltage on a lower side of the second piezoelectric layer 64 is high, to form a second electric field in a +y direction (a direction in which the second piezoelectric layer 64 faces the substrate 67). The second piezoelectric layer 64 transmits a second ultrasonic wave under excitation of the second electric field. As shown in FIG. 8, a polarization direction of the first piezoelectric layer 62 is opposite to a polarization direction of the second piezoelectric layer 64.

It can be learned from the foregoing descriptions that both the first electrode layer 61 and the third electrode layer 65 receive the excitation signal transmitted at the first ultrasonic transmit signal input port, and the second electrode layer 63 receives the excitation signal transmitted at the second ultrasonic transmit signal input port. In this way, directions of electric fields applied to the first voltage layer 62 and the second piezoelectric layer 64 are definitely opposite, and a direction of an electric field excited at the piezoelectric layer is the same as a polarization direction of the piezoelectric layer. This helps improve transmit efficiency of the fingerprint recognition module.

In this way, in a signal transmitter phase of the fingerprint recognition module, electric fields are generated on two sides of the first piezoelectric layer and the second piezoelectric layer under action of excitation signals at the first electrode layer, the second electrode layer, and the third electrode layer, and both the first piezoelectric layer and the second piezoelectric layer operate under excitation of the electric fields. This increases electric field strength at the piezoelectric layer, and improves transmit performance of the fingerprint recognition module, and a penetration capability of a transmitted ultrasonic wave is stronger.

In an embodiment, the fingerprint recognition module further includes an echo signal output port, and the echo signal output port is coupled to a circuit layer. For example, each pixel circuit at the circuit layer is coupled to the echo signal output port.

For example, as shown in FIG. 9, the array electrode block in the first electrode layer 61 is configured to collect an echo signal, and output the echo signal to the processor through the first electrode layer. In this process, for example, the second electrode layer 63 may remain in a grounded state, and the third electrode layer 65 may remain in a grounded state, or may be in a floating state.

In a signal receiver phase of the fingerprint recognition module, the reflected ultrasonic wave reaches the first piezoelectric layer, the first piezoelectric layer vibrate at a high frequency under driving of the reflected ultrasonic wave, and converts the vibration into an electrical signal. The circuit layer receives the electrical signal, and outputs the electrical signal via the echo signal output port, to receive echo signals.

When the fingerprint recognition module is used in the electronic device, as shown in FIG. 5, the fingerprint recognition module is bonded to a top-layer structure 200 through a first connection layer 100. The top-layer structure 200 includes a display panel 2, a glass cover, a metal cover, or another cover.

In an embodiment, as shown in FIG. 5, the top-layer structure 200 includes a cover 5, an optically clear adhesive (Optically Clear Adhesive, OCA) layer 201, a polarizer (POL) 202, and a display panel (panel) 2 that are sequentially disposed in a stacked manner in a y direction.

A connection manner of the fingerprint recognition module is not limited in embodiments of this application. In FIG. 5, the fingerprint recognition module is disposed below the display panel 2, and is attached to the display panel 2 through the first connection layer 100. In another embodiment of this application, the fingerprint recognition module may be disposed at any layer of the top-layer structure 200.

A material of the first connection layer is not limited in embodiments of this application. The first connection layer may be a conductive adhesive layer, or may be an insulation adhesive layer. In an embodiment, the first connection layer may use a homogeneous material, or may include a plurality of layers of composite materials. For example, the first connection layer may be an adhesive layer, or a structure in which an adhesive layer and a metal layer are alternated, and may implement a bonding function, and may further transmit an ultrasonic wave between the fingerprint recognition module and the display, to implement acoustic coupling.

In actual application, as shown in FIG. 5, a rear side of the fingerprint recognition module may be attached to a lower part of the display panel 2. In other words, the substrate 67 is attached to the lower part of the display panel 2 through the first connection layer 100. As shown in FIG. 6, a front side of the fingerprint recognition module may be attached to the lower part of the display panel 2. In other words, compared with the substrate 67, the electrode layer is closer to the display panel 2.

For example, the electronic device further includes a processor, and the processor is in a signal connection to the fingerprint recognition module. The processor is configured to: when the finger of the user approaches, control the fingerprint recognition module to start to operate.

An operating process of the fingerprint recognition module is divided into a transmitter (transmitter, TX) phase and a receiver (receiver,RX) phase.

In the transmitter phase, the first ultrasonic transmit signal input port receives the first excitation signal, and transmits the first excitation signal to the first electrode layer and the third electrode layer. The second ultrasonic transmit signal input port receives the second excitation signal, and transmits the second excitation signal to the second electrode layer. The first piezoelectric layer transmits a first ultrasonic wave under excitation of a first electric field formed by the first excitation signal and the second excitation signal on two sides of the first piezoelectric layer, and the second piezoelectric layer transmits a second ultrasonic wave under excitation of a second electric field formed by the second excitation signal and the first excitation signal on two sides of the second piezoelectric layer. An electric field direction of the first electric field is opposite to an electric field direction of the second electric field. The first ultrasonic wave and the second ultrasonic wave are transmitted to the display through each layer until a pressing object (for example, a finger) is encountered on a surface of the display. A part of the ultrasonic wave is reflected by the pressing object, and a small part of the ultrasonic wave continues to propagate forward.

As shown in FIG. 9, in the receiver phase, the first electrode layer 61 is connected to a circuit in the substrate 67 for signal processing, the second electrode layer 63 is grounded, and the third electrode layer 65 may remain in a grounded or suspended state. In this case, the reflected ultrasonic wave passes through each layer of medium again, and reaches the first piezoelectric layer 62. The first piezoelectric layer 62 vibrates at a high frequency under driving of the reflected ultrasonic wave, and converts the vibration into an electrical signal. The circuit layer receives the electrical signal, and outputs the electrical signal via the echo signal output port.

In this way, based on the fingerprint recognition module provided in this embodiment of this application, in the transmitter phase, both the first piezoelectric layer and the second piezoelectric layer serve as excitation sources, and directions of excitation electric fields are opposite. In the receiver phase, only the first piezoelectric layer receives the echo signal.

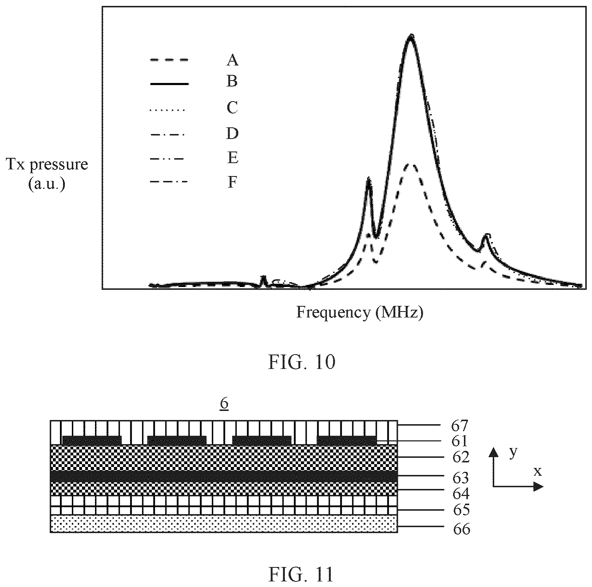

As shown in FIG. 10, a horizontal coordinate is a frequency, and a vertical coordinate is transmit acoustic pressure. A case in which a thickness of a single piezoelectric layer is the same as a total thickness of two piezoelectric layers is used as an example. A line A in FIG. 10 is a curve in which acoustic pressure of a transmit wave of the fingerprint recognition module (a single piezoelectric layer) in FIG. 3 changes with a frequency. A line B, a line C, a line D, a line E, and a line F in FIG. 10 are curves in which the acoustic pressure of the transmit wave of the fingerprint recognition module changes with the frequency at different ratios of the thickness of the first piezoelectric layer to the total thickness in FIG. 4 (two piezoelectric layers). The line B, the line C, the line D, the line E, and the line F approximately overlap. One of the lines may be used as an example for description. For example, the line B is used as an example.

A frequency corresponding to acoustic pressure of a strongest transmit wave is a resonance frequency of the fingerprint recognition module, and is also a transmit excitation frequency selected by the fingerprint recognition module. As shown in FIG. 10, it can be learned by comparing another line such as a line A and a line B that, at the resonance frequency, it can be seen that acoustic pressure of a strongest transmit wave of a fingerprint recognition module (the two piezoelectric layers shown in FIG. 4) represented by the line B is twice the acoustic pressure of the strongest transmit wave of acoustic pressure of a fingerprint recognition module (the single piezoelectric layer shown in FIG. 3) represented by the line A. In this way, transmit performance of the ultrasonic module can be improved by disposing the two piezoelectric layers.

In this way, the fingerprint recognition module provided in embodiments of this application includes at least two piezoelectric layers: the first piezoelectric layer 62 and the second piezoelectric layer 64. When a signal is transmitted, under excitation of electrodes on two sides, both the first piezoelectric layer 62 and the second piezoelectric layer 64 operate under excitation of an electric field. This increases electric field strength at the first piezoelectric layer 62 and the second piezoelectric layer 64, and improves transmit performance of the fingerprint recognition module, and a penetration capability of a transmitted ultrasonic wave is stronger.

In some embodiments, as shown in FIG. 4, the fingerprint recognition module 6 further includes a protective layer 66, and the protective layer 66 is connected to the third electrode layer 65. The protective layer is configured to protect the fingerprint recognition module.

In an embodiment, a material of the protective layer 66 includes a polymer material, for example, polyimide (Polyimide, PI).

A total thickness of the first piezoelectric layer and the second piezoelectric layer is not limited in embodiments of this application. In an embodiment, a total thickness of the first piezoelectric layer 62 and the second piezoelectric layer 64 is equal to a total thickness of the piezoelectric layers in FIG. 3. For example, the total thickness of the first piezoelectric layer 62 and the second piezoelectric layer 64 is 5 µm to 30 µm. Therefore, thicknesses of the two piezoelectric layers are small, and are close to a thickness of an existing single piezoelectric layer. This improves transmit performance of the fingerprint recognition module without increasing the total thickness of the piezoelectric layers.

In the foregoing embodiment, in the transmitter phase, both the first piezoelectric layer and the second piezoelectric layer serve as excitation sources to transmit ultrasonic waves, thereby improving transmit performance. However, in the receiver phase, only the first piezoelectric layer receives the echo signal. To further improve receiving performance of the fingerprint recognition module, an embodiment of this application further provides an improved fingerprint recognition module.

In some embodiments of this application, a thickness of the first piezoelectric layer 62 and a thickness of the second piezoelectric layer 64 may be adjusted, to improve receiving performance of the fingerprint recognition module.

For example, as shown in FIG. 11, the total thickness of the first piezoelectric layer 62 and the second piezoelectric layer 64 may not be changed. Only the ratio of the thickness of the first piezoelectric layer 62 to the total thickness of the first piezoelectric layer 62 and the second piezoelectric layer 64 is increased.

For example, a ratio of a thickness of the first piezoelectric layer 62 to a total thickness of the first piezoelectric layer 62 and the second piezoelectric layer 64 may be greater than 0.5. In this way, the first piezoelectric layer 62 is thicker. When the reflected ultrasonic wave reaches the first piezoelectric layer 62, the first piezoelectric layer 62 vibrates at a high frequency under driving of the reflected ultrasonic wave, and further converts the high-frequency vibration into a high-frequency pulse electrical signal. In this case, the first piezoelectric layer 62 accumulates more charges in a thickness direction, generates a stronger electrical signal, and has better receiving performance.

For example, a thickness of the first piezoelectric layer 62 is t1, a thickness of the second piezoelectric layer 64 is t2, a total thickness of the piezoelectric layers is t, and t satisfies: t=t1+t2, and a ratio of the thickness of the first piezoelectric layer 62 to the total thickness of the first piezoelectric layer 62 and the second piezoelectric layer 64 satisfies: ratio=t1/t.

In some embodiments of this application, ratio=0.33333, ratio=0.35 and ratio=0.66667 may be separately made, and echo signal strength changes of the fingerprint recognition module at different ratios may be obtained through simulation.

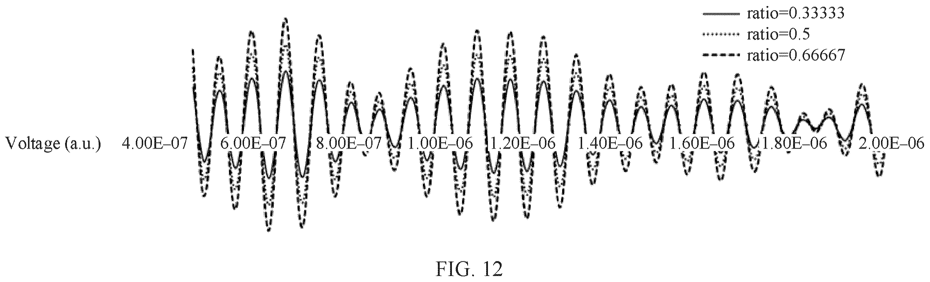

FIG. 12 is a curve diagram in which echo signal strength of the fingerprint recognition module in FIG. 11 varies with a ratio of a thickness of a first piezoelectric layer to a thickness of total piezoelectric layers. A horizontal coordinate is time, and a vertical coordinate is echo signal strength. As shown in FIG. 12, as the ratio increases, that is, when the ratio of the thickness of the first piezoelectric layer 62 to the thickness of the first piezoelectric layer 62 and the thickness of the second piezoelectric layer 64 increases, the ratio increases, the thickness of the first piezoelectric layer 62 becomes greater, receiving sensitivity of the fingerprint recognition module is significantly increased, and strength of the echo signal is significantly increased, which is close to a linear increase relationship.

In addition, as shown in FIG. 10, ratio=0.25, ratio=0.33333, ratio=0.5, ratio=0.66667 and ratio=0.75 may be separately made, and curves in which the acoustic pressure of the transmit wave of the fingerprint recognition module changes with the frequency at different ratios may be obtained through simulation.

A line B, a line C, a line D, a line E, and a line F are respectively used to represent two piezoelectric layers of different thicknesses. For example, the line B represents a curve in which acoustic pressure of a transmit wave of the fingerprint recognition module changes with a frequency when ratio=0.25, the line C represents a curve in which the acoustic pressure of the transmit wave of the fingerprint recognition module changes with the frequency when ratio=0.33333, the line D represents a curve in which the acoustic pressure of the transmit wave of the fingerprint recognition module changes with the frequency when ratio=0.5, the line E represents a curve in which the acoustic pressure of the transmit wave of the fingerprint recognition module changes with the frequency when ratio=0.66667, and the line F represents a curve in which the acoustic pressure of the transmit wave of the fingerprint recognition module changes with the frequency when ratio=0.75. The line B, the line C, the line D, the line E, and the line F approximately overlap.

Therefore, different ratios have small impact on the acoustic pressure of the ultrasonic wave transmitted by the fingerprint recognition module.

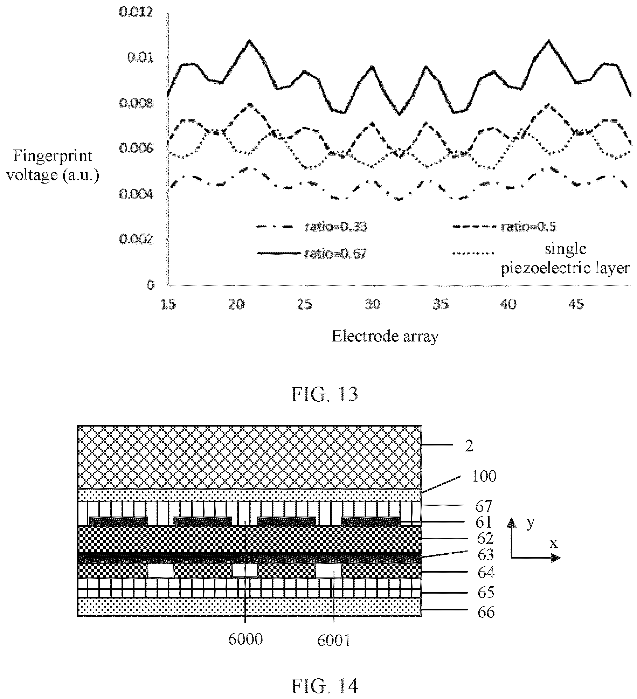

FIG. 13 is a simulation diagram of imaging effect of the fingerprint recognition module in FIG. 11 and FIG. 3. As shown in FIG. 13, a horizontal coordinate is a location of the first electrode array, and a vertical coordinate is a fingerprint signal received by the first electrode. When ratio=0.33, a signal difference between a "valley" and a "ridge" of a finger surface obtained through imaging is the smallest, signal differences between a "valley" and a "ridge" that are of a finger surface and that are obtained through imaging by the fingerprint recognition module using the single piezoelectric layer structure shown in FIG. 3 and the fingerprint recognition module using the structure shown in FIG. 4 when ratio=0.5 are close to each other, and echo sensitivity of the fingerprint recognition module using the single piezoelectric layer structure shown in FIG. 3 is basically the same as that of the fingerprint recognition module using the structure shown in FIG. 4. When ratio=0.67, signal differences between a "valley" and a "ridge" of a finger surface obtained through imaging by the fingerprint recognition module are significantly increased, a signal-to-noise ratio is higher, and imaging performance is significantly improved.

In this way, based on the fingerprint recognition module provided in this embodiment of this application, the thickness of the piezoelectric layer is adjusted, so that the first piezoelectric layer 62 is thicker, and a potential difference generated by charge accumulation in a thickness direction of the first piezoelectric layer 62 is larger, thereby improving receiving performance. In addition, a signal difference between a "valley" and a "ridge" that are of a finger surface and that are obtained through imaging by the fingerprint recognition module is increased, and imaging effect is better.

In some embodiments of this application, a gap may be further disposed between the piezoelectric layer and another electrode layer, to form an array structure, and array units of the piezoelectric layer one-to-one correspond to the electrode blocks of the first electrode layer 61. The one-to-one correspondence in this embodiment of this application is not a strict correspondence, and there may be an error. For example, a center of the array unit in the piezoelectric layer may be opposite to a center of the electrode block in the first electrode layer 61, and a size of the array unit in the piezoelectric layer may be different from a size of the electrode block in the first electrode layer 61.

In an embodiment, as shown in FIG. 14, a first gap 6000 exists between electrode blocks of the first electrode layer 61. A graphical second gap 6001 is included in the second piezoelectric layer 64, so that the second piezoelectric layer 64 has a plurality of piezoelectric units arranged in an array. A width of the second gap 6001 is not limited in embodiments of this application. For example, the width of the second gap 6001 is approximately 2 µm to 40 µm.

In an embodiment, second gaps 6001 in the second piezoelectric layer 64 one-to-one correspond to first gaps 6000 in the first electrode layer 61, and the piezoelectric units in the second piezoelectric layer 64 one-to-one correspond to the electrode blocks in the first electrode layer 61. The one-to-one correspondence in this embodiment of this application is not a strict correspondence, and there may be an error. For example, a center of the second gap 6001 may be opposite to a center of the first gap 6000, and a width of the second gap 6001 may be different from a width of the first gap 6000. Alternatively, a center of the piezoelectric unit in the second piezoelectric layer 64 may be opposite to a center of the electrode block in the first electrode layer 61, and a width of the piezoelectric unit in the second piezoelectric layer 64 may be different from a width of the electrode block in the first electrode layer 61. The width is a size in an x direction in the figure.

In an embodiment, the second gap 6001 may be filled with a dielectric material. The dielectric material may be a material whose acoustic impedance differs greatly from an acoustic impedance difference of the piezoelectric layer. For example, the piezoelectric layer is made of a low acoustic impedance material, and the dielectric material may be isolated by using a high acoustic impedance material such as metal.

In this way, compared with the gap disposed above the first electrode layer 61, the second gap 6001 can reduce impact on a path of an ultrasonic wave transmitted by the fingerprint recognition module, and the second gap 6001 can further reduce crosstalk between different pixels when the fingerprint recognition module performs receiving.

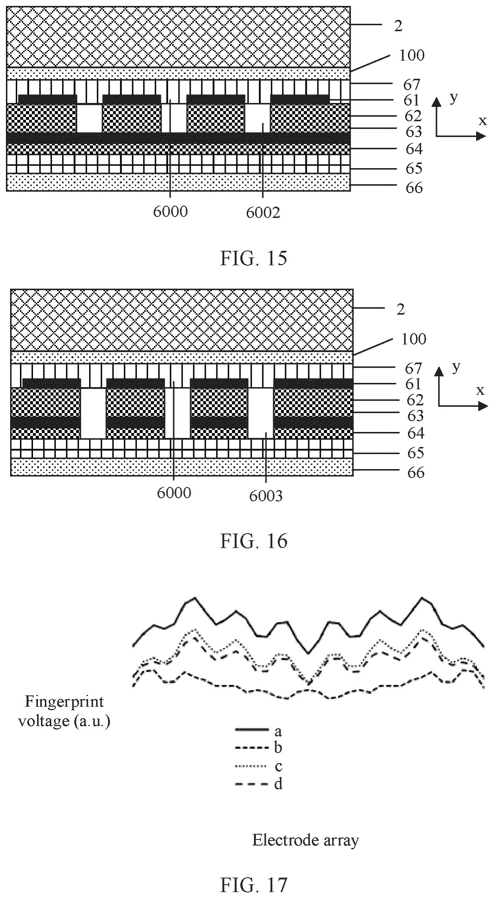

In an embodiment, as shown in FIG. 15, a graphical third gap 6002 is included in the first piezoelectric layer 62, so that the first piezoelectric layer 62 has a plurality of piezoelectric units arranged in an array. A width of the third gap 6002 is not limited in embodiments of this application, and the width of the third gap is approximately 2 µm to 40 µm.

In an embodiment, third gaps 6002 in the first piezoelectric layer 62 one-to-one correspond to first gaps 6000 in the first electrode layer 61. The piezoelectric units in the first piezoelectric layer 62 one-to-one correspond to the electrode blocks in the first electrode layer 61.

The one-to-one correspondence in this embodiment of this application is not a strict correspondence, and there may be an error. For example, a center of the third gap 6002 may be opposite to a center of the first gap 6000, and a width of the third gap 6002 may be different from a width of the first gap 6000. Alternatively, a center of the piezoelectric unit in the first piezoelectric layer 62 may be opposite to a center of the electrode block in the first electrode layer 61, and a width of the piezoelectric unit in the first piezoelectric layer 62 may be different from a width of the electrode block in the first electrode layer 61. The width is a size in an x direction in the figure.

In an embodiment, the third gap 6002 may be filled with a dielectric material.

In this way, compared with the gap disposed above the first electrode layer 61, the second gap 6001 can reduce impact on a path of an ultrasonic wave transmitted by the fingerprint recognition module, and the second gap 6001 can further reduce crosstalk between different pixels when the fingerprint recognition module performs receiving.

In an embodiment, the second electrode layer 63 may be further disposed, and the second electrode layer 63 forms an array structure. For example, as shown in FIG. 16, a graphical fourth gap 6003 is included in each of the first piezoelectric layer 62, the second piezoelectric layer 64, and the second electrode layer 63, so that the first piezoelectric layer 62, the second piezoelectric layer 64, and the second electrode layer 63 form an array structure. A width of the fourth gap 6003 is not limited in embodiments of this application. For example, the width of the gap is approximately 2 µm to 40 µm. The first gap 6000 exists between electrode blocks of the first electrode layer 61.

In an embodiment, fourth gaps 6003 one-to-one correspond to first gaps 6000 in the first electrode layer 61. The one-to-one correspondence in this embodiment of this application is not a strict correspondence, and there may be an error. For example, a center of the fourth gap 6003 may be opposite to a center of the first gap 6000, and a width of the fourth gap 6003 may be different from a width of the first gap 6000.

In an embodiment, the fourth gap 6003 may be filled with a dielectric material.

In this way, compared with the gap disposed above the first electrode layer 61, the second gap 6001 can reduce impact on a path of an ultrasonic wave transmitted by the fingerprint recognition module, and the second gap 6001 can further reduce crosstalk between different pixels when the fingerprint recognition module performs receiving.

In an embodiment, a graphical fifth gap may be further included in the third electrode layer 65. A width of the fifth gap is adjustable, and a width of the gap is approximately 2 µm to 40 µm.

In an embodiment, the gaps in the third electrode layer 65 one-to-one correspond to the gaps 1002 in the first electrode layer 61. In this way, crosstalk between different pixels when the fingerprint recognition module performs receiving can be further reduced.

FIG. 17 is a simulation diagram of imaging effect of the fingerprint recognition module in FIG. 6, FIG. 14, FIG. 15, and FIG. 16. A line a is a fingerprint imaging result of the fingerprint recognition module in FIG. 15. A line b is a fingerprint imaging result of the fingerprint recognition module in FIG. 6. A line c is a fingerprint imaging result of the fingerprint recognition module in FIG. 14. A line d is a fingerprint imaging result of the fingerprint recognition module in FIG. 16. As shown in FIG. 17, a "valley" and a "ridge" of a finger surface obtained through imaging by the fingerprint recognition module shown in FIG. 6 are not obvious, and a "valley" and a "ridge" of a finger surface obtained through imaging by the fingerprint recognition module in FIG. 14, FIG. 15, and FIG. 16 are clear, the fingerprint imaging capability is significantly improved.

Therefore, the piezoelectric layer and the electrode layer that are graphically arranged are disposed in the fingerprint recognition module, so that the piezoelectric layer and the electrode layer are arranged in an array, and one-to-one correspond to the pixel units, thereby improving a fingerprint imaging capability of the fingerprint recognition module.

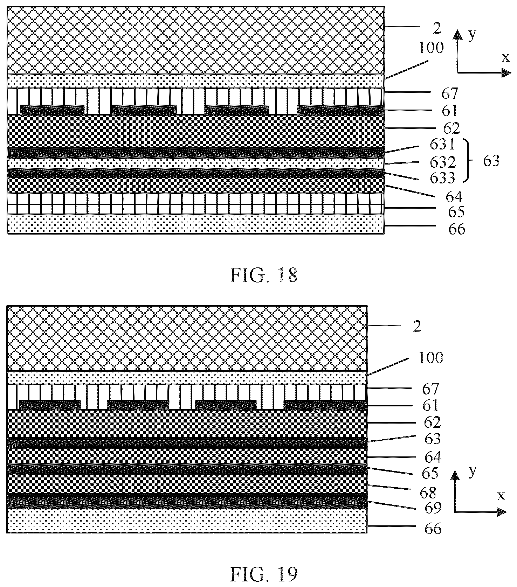

In some embodiments of this application, as shown in FIG. 18, the second electrode layer 63 may be divided into: a first sub-electrode layer 631, a connection layer 632, and a second sub-electrode layer 633, where the first sub-electrode layer 631 is close to the first piezoelectric layer 62, the second sub-electrode layer 633 is close to the second piezoelectric layer 64, and the first sub-electrode layer 631 is connected to the second sub-electrode layer 633 through the second connection layer 632.

The first electrode layer 61 may be used as an upper electrode of the first piezoelectric layer 62, the first sub-electrode layer 631 may be used as a lower electrode of the first piezoelectric layer 62, the second sub-electrode layer 633 may be used as an upper electrode of the second piezoelectric layer 64, and the third electrode layer 65 may be used as a lower electrode of the second piezoelectric layer 64.

A material of the second connection layer 632 is not limited in embodiments of this application. The second connection layer 632 may be a conductive adhesive layer, or may be an insulation adhesive layer. When the second connection layer 632 is the insulation adhesive layer, the first sub-electrode layer 631 and the second sub-electrode layer 633 may be electrically connected through an external electrical connection structure.

In some embodiments, a thickness of the second connection layer 632 is less than a thickness of the piezoelectric layer, and a material with high Young's modulus and good compactness may be used.

A quantity of piezoelectric layers is not limited in embodiments of this application, and there should be two or more piezoelectric layers.

For example, as shown in FIG. 19, in some other embodiments of this application, the fingerprint recognition module further includes a third piezoelectric layer 68 and a fourth electrode layer 69. The third piezoelectric layer 68 is located on a side that is of the third electrode layer 65 and that is away from the substrate 67, and a polarization direction of the third piezoelectric layer 68 is opposite to a polarization direction of the second piezoelectric layer 64. In this way, the third piezoelectric layer is disposed, so that the first piezoelectric layer, the second piezoelectric layer, and the third piezoelectric layer all operate under excitation of an electric field. This further improves transmit performance of the fingerprint recognition module, and a penetration capability of a transmitted ultrasonic wave is stronger.

The fourth electrode layer 69 is, for example, located on a side that is of the third piezoelectric layer 68 and that is away from the substrate 67. In this way, when a signal is transmitted, the third piezoelectric layer operates under excitation of the fourth electrode layer and the third electrode layer.

In an embodiment, both the first electrode layer 61 and the third piezoelectric layer 68 are coupled to the first ultrasonic transmit signal input port, and the second electrode layer 63 and the fourth electrode layer 69 are coupled to the second ultrasonic transmit signal input port.

For example, the first electrode layer 61 and the third piezoelectric layer 68 receive a first excitation signal (a ground signal or at a fixed level), and the second electrode layer 63 and the fourth electrode layer 69 are configured to receive a second excitation signal (a pulse signal).

Alternatively, the first electrode layer 61 and the third piezoelectric layer 68 are configured to receive a second excitation signal (a pulse signal), and the second electrode layer 63 and the fourth electrode layer 69 receive a first excitation signal (a ground signal or at a fixed level).

In this way, in the signal transmitter phase of the fingerprint recognition module, electric fields are generated on two sides of the first piezoelectric layer, the second piezoelectric layer, and the third piezoelectric layer under action of excitation signals at the first electrode layer, the second electrode layer, the third electrode layer, and the fourth electrode layer, and the first piezoelectric layer, the second piezoelectric layer, and the third piezoelectric layer all operate under excitation of the electric fields. This increases electric field strength at the piezoelectric layer, and improves transmit performance of the fingerprint recognition module, and a penetration capability of a transmitted ultrasonic wave is stronger.

In addition, when there are two or more piezoelectric layers, the thickness of the first piezoelectric layer should be greater than 1/2 of the total thickness of the piezoelectric layers.

In an embodiment, the fingerprint recognition module further includes an echo signal output port, and the echo signal output port is coupled to a circuit layer.

In a signal receiver phase of the fingerprint recognition module, the reflected ultrasonic wave reaches the first piezoelectric layer, the first piezoelectric layer vibrates at a high frequency under driving of the reflected ultrasonic wave, and converts the vibration into an electrical signal. The circuit layer receives the electrical signal, and outputs the electrical signal via the echo signal output port, to receive echo signals. It can be learned that, in the signal receiver phase, a quantity of piezoelectric layers has small impact on receiving performance of the fingerprint recognition module, and the receiving performance of the fingerprint recognition module can be improved by adjusting only the thickness of the first piezoelectric layer.

According to the fingerprint recognition module provided in this embodiment of this application, two or more piezoelectric layers with opposite polarization directions are disposed, so that the piezoelectric layers all operate under excitation of an electric field. This further increases electric field strength at the piezoelectric layer, further improves transmit performance of the fingerprint recognition module, and a penetration capability of a transmitted ultrasonic wave is stronger.

In addition, the thickness of the piezoelectric layer is adjusted, so that the first piezoelectric layer is thicker, and a potential difference generated by charge accumulation in a thickness direction of the first piezoelectric layer is larger, thereby improving receiving performance. In addition, a signal difference between a "valley" and a "ridge" that are of a finger surface and that are obtained through imaging by the fingerprint recognition module is increased, and imaging effect is better.

A quantity of piezoelectric layers is not limited in this application. A person skilled in the art may set more layers of piezoelectric layers as required. All these fall within the protection scope of this application.

An embodiment of this application further provides a method for preparing a fingerprint recognition module. The fingerprint recognition module shown in FIG. 14 is used as an example. The method for preparing the fingerprint recognition module includes the following steps.

S101: Form the fingerprint recognition module, where the fingerprint recognition module is configured to transmit and receive an ultrasonic wave.

For a structure of the fingerprint recognition module, refer to the foregoing related descriptions of the fingerprint recognition module. Details are not described herein again.

For example, step S101 includes the following.

S1011: Form a first electrode layer 61 on a substrate 67.

For example, the first electrode layer 61 includes a plurality of electrode blocks disposed in an array, which are similar to pixel electrodes in a display.

S1012: A first piezoelectric layer 62 is formed on a side that is of the first electrode layer 61 and that is away from the substrate 67.

S1013: A second electrode layer 63 is formed on a side that is of the first piezoelectric layer 62 and that is away from the substrate 67.

For example, the second electrode layer 63 is a planar electrode.

S1014: A second piezoelectric layer 64 is formed on a side that is of the second electrode layer 63 and that is away from the substrate 67.

A polarization direction of the first piezoelectric layer 62 is opposite to a polarization direction of the second piezoelectric layer 64, and a thickness of the first piezoelectric layer 62 is greater than 1/2 of a total thickness of the first piezoelectric layer 62 and the second piezoelectric layer 64.

S1015: A third electrode layer 65 is formed on a side that is of the second piezoelectric layer 64 and that is away from the substrate 67.

For example, the third electrode layer 65 is a planar electrode.

S102: Install the fingerprint recognition module below the display.

The fingerprint recognition module and the display are disposed in a stacked manner; and the fingerprint recognition module is configured to transmit an ultrasonic wave to a side on which the display is located, and receive an ultrasonic wave reflected back by the display.

In an embodiment, the display includes a touch contact layer.

The touch contact layer is disposed on a side that is of the substrate and that is away from the third electrode layer. Alternatively, the touch contact layer is disposed on a side that is of the third electrode layer and that is away from the substrate. In this way, a front label and a back label of the fingerprint recognition module are implemented.

The fingerprint recognition module provided in embodiments of this application includes at least two piezoelectric layers: the first piezoelectric layer and the second piezoelectric layer. When a signal is transmitted, under excitation of electrodes on two sides, both the first piezoelectric layer and the second piezoelectric layer operate under excitation of an electric field. This increases electric field strength at the first piezoelectric layer and the second piezoelectric layer, and improves transmit performance of the fingerprint recognition module, and a penetration capability of a transmitted ultrasonic wave is stronger.

When a signal is received, because the first piezoelectric layer is closer to the circuit layer of the substrate, the signal may be received through the first piezoelectric layer. In some embodiments, thicknesses of the first piezoelectric layer and the second piezoelectric layer may be adjusted, so that the first piezoelectric layer is thicker, and a potential difference generated by charge accumulation in a thickness direction of the first piezoelectric layer is larger, thereby improving receiving performance. In addition, a signal difference between a "valley" and a "ridge" that are of a finger surface and that are obtained through imaging by the fingerprint recognition module is increased, and imaging effect is better. In this way, receiving and sending performance of the fingerprint recognition module is improved.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A fingerprint recognition module, comprising: a substrate;
a first ultrasonic transmit signal input port and a second ultrasonic transmit signal input port that are both disposed on the substrate; and
a circuit layer, a first electrode layer, a first piezoelectric layer, a second electrode layer, a second piezoelectric layer, and a third electrode layer that are sequentially disposed on a same side of the substrate, wherein
the circuit layer comprises a plurality of circuit units, the first electrode layer comprises a plurality of electrode blocks spaced from each other, and the plurality of circuit units are correspondingly coupled to the plurality of electrode blocks; and
a polarization direction of the first piezoelectric layer is opposite to a polarization direction of the second piezoelectric layer, both the first electrode layer and the third electrode layer are coupled to the first ultrasonic transmit signal input port, and the second electrode layer is coupled to the second ultrasonic transmit signal input port.

2. The fingerprint recognition module according to claim 1, wherein the fingerprint recognition module further comprises an echo signal output port, and the echo signal output port is coupled to the circuit layer.

3. The fingerprint recognition module according to claim 2, wherein a thickness of the first piezoelectric layer is greater than 1/2 of a total thickness of the first piezoelectric layer and the second piezoelectric layer.

4. The fingerprint recognition module according to any one of claims 1 to 3, wherein the total thickness of the first piezoelectric layer and the second piezoelectric layer is 5 µm to 30 µm.

5. The fingerprint recognition module according to any one of claims 1 to 4, wherein the first piezoelectric layer comprises a plurality of first piezoelectric units arranged in an array, and the plurality of first piezoelectric units one-to-one correspond to the plurality of electrode blocks.

6. The fingerprint recognition module according to claim 5, wherein a projection of the first piezoelectric unit on the substrate coincides with a projection of the electrode block on the substrate.

7. The fingerprint recognition module according to any one of claims 1 to 6, wherein the second piezoelectric layer comprises a plurality of second piezoelectric units arranged in an array, and the plurality of second piezoelectric units one-to-one correspond to the plurality of electrode blocks.

8. The fingerprint recognition module according to any one of claims 1 to 7, wherein the second electrode layer comprises a plurality of electrode units arranged in an array, and the plurality of electrode units one-to-one correspond to the plurality of electrode blocks.

9. The fingerprint recognition module according to any one of claims 1 to 8, wherein a width of a gap between two adjacent electrode block units is 2 µm to 40 µm.

10. The fingerprint recognition module according to any one of claims 1 to 9, wherein the second electrode layer comprises: a first sub-electrode layer, a connection layer, and a second sub-electrode layer that are disposed in a stacked manner, the first sub-electrode layer is connected to the first piezoelectric layer, the second sub-electrode layer is connected to the second piezoelectric layer, and the first sub-electrode layer is connected to the second sub-electrode layer through the connection layer.

11. The fingerprint recognition module according to claim 10, wherein a material of the connection layer comprises a conductive material or an insulating material.

12. The fingerprint recognition module according to any one of claims 1 to 11, further comprising a protective layer, wherein the protective layer is disposed on a side that is of the third electrode and that is away from the substrate.

13. The fingerprint recognition module according to any one of claims 1 to 12, further comprising a third piezoelectric layer, wherein the third piezoelectric layer is located on the side that is of the third electrode layer and that is away from the substrate, and a polarization direction of the third piezoelectric layer is opposite to the polarization direction of the second piezoelectric layer.

14. The fingerprint recognition module according to any one of claims 1 to 13, further comprising a fourth electrode layer, wherein the fourth electrode layer is located on a side that is of the third piezoelectric layer and that is away from the substrate, and the fourth electrode layer is coupled to the second ultrasonic transmit signal input port.

15. The fingerprint recognition module according to any one of claims 1 to 14, wherein the first ultrasonic transmit signal input port and the second ultrasonic transmit signal input port are configured to receive different excitation signals.

16. A display apparatus, comprising a display and the fingerprint recognition module according to any one of claims 1 to 15.

17. The display apparatus according to claim 16, wherein the display is disposed on a side that is of the substrate and that is away from the third electrode layer; or
the display is disposed on a side that is of the third electrode layer and that is away from the substrate.

18. An electronic device, comprising a processor and the display apparatus according to claim 16 or 17, wherein the processor is in a signal connection to the fingerprint recognition module.

19. An operating method of a fingerprint recognition module, wherein the fingerprint recognition module comprises a substrate, and a first ultrasonic transmit signal input port, a second ultrasonic transmit signal input port, a circuit layer, a first electrode layer, a first piezoelectric layer, a second electrode layer, a second piezoelectric layer, and a third electrode layer that are disposed on the substrate; the circuit layer comprises a plurality of circuit units spaced from each other; the first electrode layer comprises a plurality of electrode blocks spaced from each other; the plurality of circuit units are correspondingly coupled to the plurality of electrode blocks;
a polarization direction of the first piezoelectric layer is opposite to a polarization direction of the second piezoelectric layer; and
the operating method of the fingerprint recognition module comprises:
in a transmitter phase,
receiving, by the first ultrasonic transmit signal input port, a first excitation signal, and transmitting the first excitation signal to the first electrode layer and the third electrode layer; receiving, by the second ultrasonic transmit signal input port, a second excitation signal, and transmitting the second excitation signal to the second electrode layer; transmitting, by the first piezoelectric layer, a first ultrasonic wave under excitation of a first electric field formed by the first excitation signal and the second excitation signal on two sides of the first piezoelectric layer; transmitting, by the second piezoelectric layer, a second ultrasonic wave under excitation of a second electric field formed by the second excitation signal and the first excitation signal on two sides of the second piezoelectric layer, wherein an electric field direction of the first electric field is opposite to an electric field direction of the second electric field; and
in a receiver phase,
vibrating, by the first piezoelectric layer under driving of a reflected ultrasonic wave, and converting the vibration ultrasonic wave into an electrical signal; and receiving, by the circuit layer, the electrical signal, and outputting the electrical signal via an echo signal output port.
